# EUROPÄISCHE PATENTSCHRIFT

(11) **EP 0 904 424 B1**
(45) Veröffentlichungstag und Bekanntmachung des Hinweises auf die Patenterteilung: **19.07.2000**
(21) Anmeldenummer: 97923833.4
(22) Anmeldetag: 22.05.1997
(51) Int. Cl.: C23C 14/54

(54) **BESCHICHTUNGSVORRICHTUNG UND VERFAHREN ZUR BESCHICHTUNG EINES BAUTEILS MIT EINER WÄRMEDÄMMSCHICHT**
COATING DEVICE AND PROCESS FOR COATING A COMPONENT WITH A HEAT INSULATING LAYER
DISPOSITIF DE REVETEMENT ET PROCEDE DE REVETEMENT D'UN COMPOSANT PAR UNE COUCHE THERMO-ISOLANTE

(30) Priorität: 30.05.1996 DE 19621755
(43) Veröffentlichungstag der Anmeldung: 31.03.1999
(73) Patentinhaber: SIEMENS AKTIENGESELLSCHAFT, 80333 München (DE)
(72) Erfinder: BEELE, Wolfram, D-40883 Ratingen (DE); HAYESS, Burkhard, D-12435 Berlin (DE)
(86) Internationale Anmeldenummer: DE9701037
(87) Internationale Veröffentlichungsnummer: WO9746729

(56) Entgegenhaltungen:
- EP-A- 0 005 641
- US-A- 4 676 994
- US-A- 5 238 752
- SOLID STATE TECHNOLOGY, Bd. 25, Nr. 4, 1.April 1982, Seiten 136-138, XP002040112 G.V.NESSLACE: "A microprocessor controlled, dry pumped, high-vacuum coating system for thick film depositions"

## Beschreibung

Die Erfindung betrifft ein Verfahren zur Beschichtung eines Bauteils mit einer Wärmedämmschicht, bei dem das Bauteil in einer Beschichtungskammer angeordnet wird. Die Erfindung betrifft weiterhin eine Beschichtungsvorrichtung zur Herstellung einer Wärmedämmschicht auf dem Bauteil mit einer Beheizungseinrichtung zur Erwärmung des Bauteils und einer Vakuumerzeugungseinrichtung.

In der US-PS 5,238,752 ist ein Verfahren zur Herstellung eines Wärmedämmschichtsystems mit einem intermetallischen Haftvermittlungsüberzug für ein kleines metallisches Bauteil, insbesondere eine Flugtriebwerksschaufel mit einer Längsausdehnung von etwa 5 cm, beschrieben. Die eigentliche Wärmedämmschicht aus Zirkonoxid wird mittels eines Elektronenstrahl-PVD(Physical-Vapour-Deposition)-Verfahrens auf dem Bauteil abgeschieden, wobei mit einer Elektronenstrahlkanone aus einem metalloxidischen Körper Zirkon- und Yttriumoxide verdampft werden. Das Verfahren wird in einer Vorrichtung durchgeführt, in der das Bauteil vor dem Beschichtungsvorgang auf eine Temperatur von etwa 950 °C bis 1000 °C vorgeheizt wird. In der Vorrichtung ist eine Heizung vorgesehen mit der das Bauteil von oben ggf. zusätzlich zu der Aufheizung durch das abzuscheidende Zirkonoxid und durch die von der Oberfläche des verdampfenden Keramikkörpers ausgehende Strahlung aufgeheizt werden kann. In der Vorrichtung wird zur Abscheidung des Zirkonoxids ein Vakuum von etwa 7 x 10⁻³ Pa (7x10⁻⁵ mbar) erzeugt und mit der Elektronenstrahlkanone eine Abscheidungsrate von etwa 100 µm/h bis 250 µm/h erzielt. Bei diesen Betriebseinstellungen soll sich auf dem kleinen metallischen Bauteil eine Wärmedämmschicht aus Zirkonoxid mit stabförmiger Mikrostruktur ausbilden.

In der US-PS 4,676,994 ist ein Verfahren zum Abscheiden einer keramischen Beschichtung auf einem Substrat, welches eine keramische Oberfläche aufweist, beschrieben. Hierbei wird ein erstes keramisches Material in Vakuum durch einen Elektronenstrahl so aufgeheizt, daß es ein unterstöchiometrisches keramisches Fluid bildet. Das Substrat wird in Vakuum auf eine Temperatur von über 900 °C erhitzt und darauf das erste keramische Material unterstöchiometrisch aufgedampft, um eine dichte Keramikschicht zu bilden. Auf diese dichte Keramikschicht wird eine Schicht aus einer stengelförmig ausgerichteten Keramik aufgebracht. Während der Dampfabscheidung der unterstöchiometrischen Keramik zur Erzeugung der dichten Keramikschicht wird die Substrattemperatur auf einem Wert zwischen 900 °C und 1200 °C gehalten und der Vakuumdruck liegt vorzugsweise unter 13 x 10⁻³ Pa. Während der Beschichtung der dichten Keramikschicht mit der stengelförmigen Keramikschicht liegt ein Sauerstoffpartialdruck zwischen 60 x 10⁻³ Pa bis 0,27 Pa vor und der gesamte Partialdruck anderer Gase beträgt weniger als 10% des gesamten Druckes. Das Verfahren wurde beispielsweise an einer Gasturbinenschaufel mit einer maximalen Länge von 10 cm durchgeführt.

In der DE 195 22 331 A1 ist ein Verfahren zum kathodischen Bogenverdampfen für die Herstellung insbesondere von Metalloxidschichten und von Schichten von Legierungsoxiden beschrieben. Hierbei wird durch kathodisches Bogenverdampfen ein Target in einer Atmosphäre mit Sauerstoff verdampft, so daß das Oxid der Metall-Legierung im wesentlichen in einer einzigen kristallographen Phase vorliegt. Der Sauerstoff-Partialdruck während des Beschichtungsprozesses wird beobachtet und Abweichungen von einem Soll-Partialdruck werden durch Stellen zumindest einer der Größen Sauerstoff-Massenfluß, Bogenbrennspannung oder Feldstärke eines zur Targetfläche im wesentlichen senkrechten Magnetfeldes minimalisiert. Alternativ wird die Brennspannung beobachtet und werden Abweichungen von einer Soll-Brennspannung durch Stellen mindestens einer der Größen Sauerstoff-Massenfluß oder des genannten Magnetfeldes minimalisiert. Als dritte alternative Möglichkeit wird das Frequenzspektrum des Entladestroms beobachtet und Abweichungen charakteristischer Komponenten des Spektrums von Soll-Charakteristika durch Stellen der Brennstoffspannung, des Sauerstoff-Massenflusses oder des genannten Magnetfeldes minimiert. Das Stellen der obengenannten Größen erfolgt vorzugsweise automatisch durch einen Prozeßarbeitspunkt-Regelkreis. Das Verfahren ist dabei ausschließlich auf das Aufbringen einer Beschichtung aus einem Aluminiumoxid oder einem Chromoxid gerichtet.

In der DD-PS 299 902 A7 ist ein Verfahren zum Betreiben eines Plasmabogens einer Hohlkathodenverdampferquelle beschrieben, bei dem bei Auftreten betriebsbedingter Unregelmäßigkeiten des Plasmabogens eine Notabschaltung weitgehend verhindert ist. Hierbei wird in Abhängigkeit von einem Spannungsabfall zwischen der Hohlkathode und dem Verdampfertiegel oder von dem sich vom Potential der Vakuumkammer über einen Widerstand zur Anode einstellenden Ableitstrom ein logisches Signal gebildet wird. Je nach Wert dieses logischen Signals werden Maßnahmen ergriffen, um eine Notabschaltung zu verhindern.

In dem Artikel "Zirconia thin film deposition on silicon by reactive gas flow sputtering: the influence of low energy particle bombardment" von T. Jung und A. Westphal, in Material Sience and Engineering, A 140, 191, Seiten 528 bis 533, ist zur Herstellung einer Zirkonoxid-Schicht auf einem Halbleitersubstrat, insbesondere auf Silizium-Basis, das sogenannte reaktive Gasflußsputter-Verfahren angegeben. Gemäß diesem Sputter-Verfahren wird ein Inertgas, insbesondere Argon, durch eine Hohlkathode geführt, in deren Inneren eine Anode angeordnet ist, so daß eine Ionisation der Argon-Atome stattfindet. Diese treffen auf der metallischen aus Zirkon bestehenden Kathode auf, wodurch aus dieser Metallatome und/ oder Metallcluster herausgelöst und mit dem Inertgasstrom mitgeführt werden. Außerhalb der Kathode wird für eine vollständige Oxidation des metallischen Zirkons Sauerstoff mit einem Partialdruck von 10 Pa bis etwa 10⁻⁴ Pa zugeführt. Das Halbleitersubstrat ist in einer aus rostfreiem Stahl bestehenden und bis auf 800 °C beheizbaren Halterung befestigt und auf eine Temperatur von etwa 400 °C aufgeheizt. Das Verfahren wird in einer Beschichtungskammer durchgeführt, die auf ein Hochvakuum von etwa 10⁻⁷ Pa evakuiert wird. Die Abscheidungsrate liegt bei etwa 0,9 µm h⁻¹.

Eine alternative Ausbildung einer Hohlkathode für das reaktive Gasflußsputter-Verfahren ist in dem Artikel "High rated desposition of alumina films by reactive gas flow sputtering" von T. Jung und A. Westphal, in Surface and Coatings Technology, 59, 1993, Seiten 171 bis 176, beschrieben. Die darin angegebene Hohlkathode ist linear aufgebaut in dem Sinne, daß in einem Gehäuse Platten aus Zirkon nebeneinander angeordnet sind. Zwischen jeweils zwei benachbarten Platten ist ein Inertgasstrom hindurchführbar, so daß sich zwischen benachbarten Platten ein Plasma aus Inertgasatomen bildet. Mit dem Verfahren wurden Testkörper aus Silizium, rostfreiem Stahl und Glas mit Aluminiumoxid beschichtet. Während der Beschichtung betrug die Temperatur eines Testkörpers zwischen 100 °C und 200 °C. Der Druck innerhalb der Beschichtungskammer lag bei etwa 10⁻⁸ Pa und die zugeführte Sauerstoffmenge bei 4,5 cm³ min⁻¹. Die abgeschiedene Aluminiumschicht hatte eine Dicke von zwischen 0,5 µm bis 6,0 µm und eine im wesentlichen γ-Mikrostruktur.

Aufgabe der Erfindung ist es, ein Verfahren zur Beschichtung eines Bauteils mit einer keramischen, stengelkristallinen Wärmedämmschicht zur Erzielung einer hohen Beständigkeit gegenüber thermischen Wechselbeanspruchungen anzugeben. Eine weitere Aufgabe der Erfindung besteht darin, eine Beschichtungsvorrichtung zur Herstellung einer keramischen, stengelkristallinen Wärmedämmschicht auf einem Bauteil anzugeben.

Die auf ein Verfahren zur Beschichtung eines Bauteils mit einer Wärmedämmschicht gerichtete Aufgabe wird dadurch gelöst, daß das Bauteil in einer Beschichtungskammer angeordnet und auf einer Bauteiltemperatur gehalten wird, sowie in der Beschichtungskammer ein Vakuum eingestellt wird, wobei zumindest während der Abscheidung der Wärmedämmschicht auf dem Bauteil mehrere Prozeßgrößen, insbesondere Vakuumdruck, Bauteiltemperaturen und Atmosphärenzusammensetzung gemeinsam geregelt werden, so daß die sich durch Wechselwirkungen beeinflussenden Prozeßgrößen in einem jeweiligen Sollwertebereich liegen und die Wärmedämmschicht mit einer Stengelstruktur mit Keramikstengeln auf dem Bauteil aufwächst. Durch die erfindungsgemäße geregelte Prozeßführung liegen die Prozeßgrößen in einem einzuhaltenden Parameterfenster, wodurch die Einhaltung der erforderlichen Schichtstruktur gewährleistet ist. Die wesentlichen Prozeßgrößen werden gemeinsam und gleichzeitig geregelt.

Solche Sollwertbereiche sind beispielsweise bekannten Strukturzonenmodellen für mittels PVD (Physical Vapour Deposition) erzeugten Beschichtungen oder aus experimentellen Untersuchungen entnehmbar. Durch eine gemeinsame und gleichzeitige Regelung des Vakuumdrucks, der Bauteiltemperatur und der Atmosphäre während des Beschichtungsprozesses ist gewährleistet, daß die Prozeßgrößen sicher in den vorgegebenen Sollwertbereichen liegen und somit eine Wärmedämmschicht mit einer stabförmigen Mikrostruktur entsteht. Dies ist insbesondere gegenüber einem Verfahren vorteilhaft, bei dem lediglich eine nichtüberwachte Voreinstellung der Prozeßgrößen durchgeführt wird oder eine unabhängige Regelung bzw. Steuerung jeder einzelnen Prozeßgröße erfolgt, da in diesen Fällen die Gefahr besteht, daß obwohl eine Prozeßgröße in dem erlaubten Sollwertbereich liegt, die andere Prozeßgröße außerhalb des Sollwertbereiches liegt. Dies birgt die Gefahr, daß nicht ständig während des Beschichtungsprozesses eine Wärmedämmschicht mit hinreichender stabförmiger Mikrostruktur abgeschieden wird. Diese Gefahr besteht insbesondere bei großen Bauteilen und solchen Bauteilen, wie Gasturbinenschaufeln von Industriegasturbinen, mit stark schwankender räumlicher Massenkonzentration. Bei solchen Bauteilen kann z.B. mit zunehmender Dicke der Wärmedämmschicht ein lokaler Wärmeverlust durch Strahlung und/oder Wärmeleitung innerhalb des Bauteils stattfinden, so daß zur Ausbildung einer stabförmigen Mikrostruktur der Wärmedämmschicht eine ständige Überwachung und Regelung der tatsächlichen Temperatur des Bauteils und einer weiteren Prozeßgröße innerhalb der Beschichtungskammer erforderlich sein kann.

Eine Wärmedämmschicht mit stabförmiger Mikrostruktur, bei der stabförmige Keramikstengel vorzugsweise normal zur Oberfläche des Bauteils orientiert sind, ist besonders gut geeignet, thermische Wechselbeanspruchungen aufzunehmen. Hierzu ist insbesondere eine feine Stengelstruktur mit einem mittleren Stengeldurchmesser von unter 10 µm, insbesondere unter 5 µm, besonders vorteilhaft, da hierdurch eine hohe Dehnungstoleranz erzielt wird. Es werden Unterschiede in den Wärmeausdehnungskoeffizienten des insbesondere metallischen Bauteils und der keramischen Wärmedämmschicht gut ausgeglichen. Dies ist besonders für Bauteile einer Industriegasturbine, wie einer Brennkammerauskleidung und einer Gasturbinenschaufel vorteilhaft, da diese Temperaturschwankungen zwischen Raumtemperatur und mehr als 1000 °C ausgesetzt sind. Als Wärmedämmschichten eignen sich hierbei metalloxidische Keramiken, z.B. auf Basis von mit Yttriumoxid teilstabilisiertem Zirkonoxid oder Metall-Nitride. Als Verfahren zur Erzeugung des die Wärmedämmschicht bildenden Materials eignen sich sämtliche PVD-Verfahren, wie beispielsweise ein Elektronenstrahl-PVD-Verfahren, das reaktive Gasflußsputter-Verfahren oder Verfahren, die bis zur Verdampfung des Beschichtungsmaterials führen, z.B. Thermisches Spritzen in Hochvakuum.

Vorzugsweise werden neben den Prozeßgrößen Vakuumdruck und Bauteiltemperatur zur Erzielung einer Wärmedämmschicht mit stabförmiger Mikrostruktur weitere insbesondere die Gas- oder Atmosphärenzusammensetzung bestimmende Prozeßgrößen und/oder Anlagegrößen gemeinsam geregelt, so daß ohne menschlichen Eingriff der gesamte Beschichtungsprozeß automatisch abläuft. Selbst bei Störungen in der entsprechenden Beschichtungsvorrichtung kann damit flexibel auf den Beschichtungsprozeß automatisch Einfluß genommen werden. Mit einer echtzeitmäßigen Überwachung der relevanten Prozeßgrößen, insbesondere Vakuumdruck, Bauteiltemperatur und Gaszusammensetzung in der Beschichtungskammer, erfolgt eine Prozeßadaption auch bei Einwirkung von Störgrößen. Wird während des Beschichtungsprozesses in die Beschichtungskammer ein Reaktivgas eingeführt, so erfolgt vorzugsweise eine gemeinsame Regelung der Prozeßgröße Zuflußmenge an Reaktivgas und/oder Partialdruck des Reaktivgases mit den anderen Prozeßgrößen. Durch eine geregelte Zuführung des Reaktivgases ist die geeignete chemische Zusammensetzung der Wärmedämmschicht gewährleistet. Insbesondere bei einer Wärmedämmschicht aus einer metalloxidischen Keramik wird durch Zuführung von Sauerstoff als Reaktivgas eine vollständige Oxidation des Metalls, beispielsweise Zirkon, Magnesium oder Aluminium, erreicht. Bei Verwendung von Stickstoff als Reaktionsgas wird die vorgegebene Nitrierung entsprechender Metalle erreicht.

Mit den Prozeßgrößen werden vorzugsweise die Anlagenzustände- und größen, welche einen Einfluß auf die Abscheidung der Wärmedämmschicht haben, gemeinsam geregelt. Hierzu gehört beispielsweise die Regelung einer Relativbewegung, die das Bauteil gegenüber einer Beschichtungsquelle zur Erzeugung des Materials der Wärmedämmschicht ausführt. Diese Relativbewegung ist vorzugsweise eine Rotation des Bauteils um eine Längsachse, so daß auf der gesamten Oberfläche des Bauteils das Material, beispielsweise mit Yttriumoxid teilstabilisiertes Zirkonoxid, gleichmäßig abgeschieden wird. Der Relativbewegung kann eine weitere Bewegung überlagert sein, z.B. eine Translation zwecks Beschichtung von Bauteilen mit großer Längsdehnung. Eine weitere Anlagengröße, die insbesondere die Geschwindigkeit des Wachstums der Wärmedämmschicht bedingt, ist die Materialabgabe der Beschichtungsquelle. Bei einem Elektronenstrahl-PVD-Verfahren wird diese charakterisiert durch die Leistung der Elektronenstrahlkanone, mit der Keramikteilchen aus einem Keramikkörper verdampft werden, und dem Vorschub des Beschichtungsmaterials. Bei Anwendung des reaktiven Gasflußsputter-Verfahrens ist für die Materialabgabe der Beschichtungsquelle die Spannung zwischen Kathode und Anode sowie die Durchflußmenge des Inertgases, wie Argon, von Bedeutung.

Der Sollwertebereich der Bauteiltemperatur liegt insbesondere bei Beschichtung einer metallischen Komponente einer Gasturbinenanlage zwischen 900 °C und 1150 °C, insbesondere zwischen 950 °C und 1050 °C. Der Sollwertebereich des Vakuumdrucks liegt bei Anwendung des reaktiven Gasflußsputter-Verfahrens zwischen 10⁻³ mbar und 10⁻⁷ mbar, insbesondere zwischen 10⁻⁴ mbar und 10⁻⁶ mbar. Bei den genannten Sollwertebereichen für Bauteiltemperatur und Vakuumdruck ist eine gute Haftung der Metallkeramikschicht an dem Bauteil, ggf. unter Vermittlung einer oder mehrerer Haftschichten, sowie ein guter Ausgleich der unterschiedlichen Wärmeausdehnungskoeffizienten durch die stabförmige Mikrostruktur der Wärmedämmschicht gegeben. Der Partialdruck des Reaktivgases liegt vorzugsweise in einem Sollwertbereich zwischen 10⁻³ mbar und 10⁻¹ mbar, insbesondere um 10⁻² mbar. Hierdurch ist gewährleistet, daß Reaktivgas, Sauerstoff zur Oxidation bzw. Stickstoff zur Nitrierung, in ausreichender Menge vorhanden ist, wodurch die erforderliche chemische Zusammensetzung der Wärmedämmschicht gewährleistet ist.

Das Verfahren eignet sich besonders für ein Bauteil mit Teilbereichen stark unterschiedlicher Massenkonzentration. In dem Bauteil wird vorzugsweise eine weitgehend gleichmäßige Durchwärmung eingestellt. Dies ist insbesondere bei Turbinenschaufeln vorteilhaft, bei denen ein dünnwandiger Schaufelprofilteil und ein dickwandiger Fußteil bzw. Deckplattenteil vorhanden sind. Die gleichmäßige Durchwärmung sowie die Einhaltung eines Sollwertbereiches der Bauteiltemperatur gewährleisten über die gesamte zu beschichtende Oberfläche des Bauteils eine gleichmäßig gute Anhaftung der Wärmedämmschicht sowie die Ausbildung der stengelförmigen Mikrostruktur. Vorzugsweise wird eine maximale Temperaturspanne von ± 50 K als Abweichung vom Sollwert nicht überschritten. Die Wandstärke in dem ersten Teilbereich, dem dünnwandigen Teilbereich, steht mit der Wandstärke des zweiten Teilbereichs, des dickwandigen oder vollmetalligen Teils, in einem Verhältnis von 1:5 bis 1:200, insbesondere von 1:10 bis 1:100. Das Bauteil, insbesondere eine Turbinenschaufel einer Industriegasturbine, kann ein Gewicht von zwischen 1 kg und 15 kg aufweisen. Bei einer Laufschaufel kann der dünnwandige sich entlang einer Längsachse erstreckende Schaufelprofilbereich eine Ausdehnung von mehr als 20 cm aufweisen.

Die auf eine Beschichtungsvorrichtung zur Herstellung einer Wärmedämmschicht auf einem Bauteil gerichtete Aufgabe wird durch eine Vorrichtung gelöst, die eine Beheizungseinrichtung zur Erwärmung des Bauteils und zumindest einen Temperaturgeber zur Bestimmung der Temperatur des Bauteils sowie eine Vakuumerzeugungseinrichtung, insbesondere eine Vakuumpumpe, und eine Vakuumdruckmeßeinrichtung aufweist, wobei die Einrichtungen sowie der Temperaturgeber mit einer Regeleinrichtung zur gemeinsamen und gleichzeitigen Regelung mehrerer Prozeßgrößen des Beschichtungsprozesses, wie Temperatur des Bauteils, Vakuumdruck und Gaszusammensetzung, verbunden sind. Durch eine Beschichtungsvorrichtung, bei der während des Beschichtungsprozesses die Temperatur des Bauteils, der Vakuumdruck und die Atmosphärenzusammensetzung in der Beschichtungsvorrichtung ständig überwachbar sind und diese Prozeßgrößen, Temperatur, Vakuumdruck und Atmosphärenzusammensetzung, über eine Regeleinrichtung gemeinsam regelbar sind, ist gewährleistet, daß die zur Erzielung einer stabförmigen Mikrostruktur der Wärmedämmschicht erforderlichen Sollwertebereiche der Prozeßgrößen eingehalten werden. Mit der Vorrichtung können somit auch Bauteile mit stark lokal schwankender Massenkonzentration, wie eine Turbinenschaufel einer Industriegasturbine, mit einer Wärmedämmschicht beschichtet werden, welche eine gute Haftung an das Bauteil sowie eine hohe Beständigkeit gegenüber thermischen Wechselbeanspruchungen aufweist. Mit der Regeleinrichtung sind weitere Prozeßgrößen sowie Anlagegrößen zum Betrieb der Beschichtungsvorrichtung gemeinsam regelbar. Hierdurch sind neben den Bedingungen zur Erreichung einer stabförmigen Mikrostruktur der Wärmedämmschicht auch noch die Abscheidungsrate, der Oxidationsgrad des die Wärmedämmschicht bildenden Materials, insbesondere einem Metalloxid, sowie eine Bewegungssteuerung des Bauteils in der Beschichtungsvorrichtung gegeben.

Die Beschichtungsvorrichtung weist zur Durchführung des reaktiven Gasflußsputter-Verfahrens eine Beschichtungsquelle umfassend eine Hohlkathode, welche von einem Inertgas, wie Argon, durchströmbar ist, ein Kathodenmaterial und eine Anode umfaßt, auf. Weiterhin verfügt sie über eine Halteeinrichtung zur Positionierung des Bauteils, wobei die Hohlkathode eine der Halteeinrichtung zugewandte Gasauslaßöffnung sowie eine Gaseinlaßöffnung für das Inertgas besitzt. Das Kathodenmaterial besteht vorzugsweise aus einer Legierung umfassend Zirkon und ein Stabilisatormetall, wie Yttrium. Weiterhin ist eine Zuführung für ein reaktives Gas, insbesondere eine Oxidationsmittelzuführung für eine Oxidation des Zirkons außerhalb der Hohlkathode, vorgesehen. Das aus der Hohlkathode mit dem Inertgas herausgeführte Zirkon bzw. Yttrium wird durch Zuführung von Sauerstoff vollständig oxidiert und scheidet sich auf dem Bauteil als eine mit Yttriumoxid teilstabilisierte Zirkonoxid-Wärmedämmschicht ab. Diese Wärmedämmschicht hat eine stengelförmige Mikrostruktur mit einem mittleren Durchmesser von vorzugsweise zwischen 0,3 µm und 5,0 µm, wobei die Keramikstengel im wesentlichen normal zur Oberfläche des Bauteils gerichtet sind. Selbstverständlich ist es möglich, die Kathode aus einem anderen Material, wie Magnesium oder Aluminium, herzustellen. Dem aus der Hohlkathode austretenden Metall kann anstelle von Sauerstoff auch Stickstoff zugeführt werden, wodurch entsprechende Metallnitride entstehen. Die Beschichtungsvorrichtung kann ebenfalls zur Ausführung eines Elektronenstrahl-PVD-Verfahrens mit einer entsprechenden Elektronenstrahlkanone und weiteren hierfür erforderlichen Komponenten ausgeführt sein, welche über die Regeleinrichtung entsprechend der geforderten Sollwertbereiche der Prozeßgrößen geregelt werden. Prozeßgrößen können hierbei die elektrischen Größen (Spannung/Strom oder Spannung/Leistung) der Elektronenstrahlkanone, die Regelgrößen der Defokussier- und Elektronenstrahlablenksysteme sowie Pumpregelgrößen, wie Druck in Kathodenkammer und/oder Druck in Zwischenstufe, sein.

Die Regeleinrichtung ist vorzugsweise hierarchisch aufgebaut mit einem Mastersystem zur Koordination des Gesamtablaufes des Beschichtungsprozesses und einer Mehrzahl von Subsystemen zur Regelung jeweils einer oder mehrerer Prozeß- und/oder Anlagengrößen. Das Mastersystem sowie die Subsysteme können räumlich voneinander getrennt angeordnet sein. Mit dem Mastersystem ist eine echtzeitgerechte Überwachung der relevanten Prozeß- und Anlagengrößen für eine Gesamtprozeßregelung, insbesondere bei Einwirkung von Störgrößen gegeben. Die Subsysteme werden über das Mastersystem verwaltet. Durch eine entsprechende Programmierung des Mastersystems, welches bevorzugt als speicherprogrammierbare Prozeßsteuerung ausgebildet ist, ist eine flexible Definition des gesamten Beschichtungsprozesses gegeben. Hierdurch kann eine definierte und stabile Umgebungsbedingung in der Beschichtungsatmosphäre für das Bauteil, insbesondere eine Turbinenschaufel, erreicht werden. Für eine solche Turbinenschaufel ist somit auf einfache Art und Weise eine definierte Schichtdickenverteilung entlang der zu beschichtenden Oberfläche durch die flexible Prozeßführung gegeben. Die Einhaltung der Sollwertbereiche der wesentlichen Beschichtungsprozeßparameter, wie Temperatur des Bauteils, Vakuumdruck und Gaszusammensetzung, wird durch die Regeleinrichtung sicher eingehalten.

Anhand der in der Zeichnung dargestellten Ausführungsbeispiele werden das Verfahren zum Beschichten eines Bauteils sowie die Beschichtungsvorrichtung, welche der Übersichtlichkeit halber teilweise schematisch und nicht maßstäblich dargestellt sind, näher erläutert. Es zeigen:
- FIG 1,2: eine schematische Darstellung jeweils einer Beschichtungsvorrichtung mit Regeleinrichtung und
- FIG 3: einen Aufbau einer Regeleinrichtung.

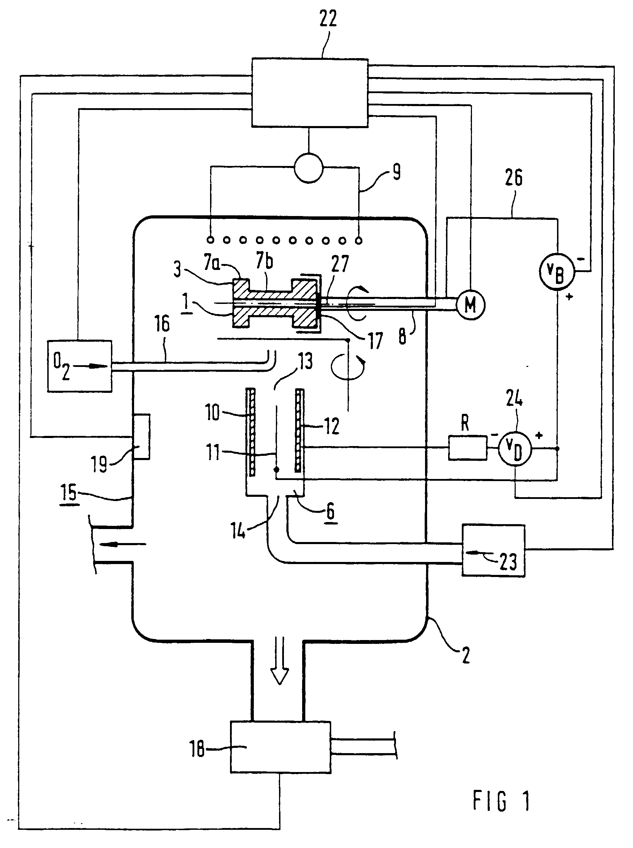

In FIG 1 ist schematisch und nicht maßstäblich eine Beschichtungsvorrichtung 15 zur Durchführung eines reaktiven Gasflußsputter-Verfahrens dargestellt. Die Beschichtungsvorrichtung weist eine Beschichtungskammer 2 auf, in der durch eine Vaku umerzeugungseinrichtung 18 ein Vakuum von unter 1 mbar erzeugbar ist. Innerhalb der Beschichtungskammer 2 ist eine entlang einer Längsachse gerichtete Hohlkathode 10 mit kreiszylindrischem Querschnitt angeordnet. Innerhalb der Hohlkathode 10 ist eine stabförmige Anode 11 angeordnet, die über eine Gleichspannungsversorgung 24 mit der Hohlkathode 10 verbunden ist. Die Gleichspannungsversorgung 24 ist ebenfalls mit der Regeleinrichtung 22 verbunden. Die Hohlkathode 10 weist ein Kathodenmaterial 12 auf, welches als Hohlzylinder ausgebildet ist, oder beispielsweise aus einzelnen die Innenwandung der Hohlkathode 10 ausfüllenden Platten besteht. Das Kathodenmaterial 12 ist Zirkon, dem in einem vorgegebenen Verhältnis, beispielsweise 3 Gew.-% bis 10 Gew.-%, Yttrium zulegiert ist. Die Hohlkathode 10 weist eine Gaseinlaßöffnung 14 auf, die mit einer nichtdargestellten Gasversorgung zur Einleitung eines Inertgases 23, insbesondere Argon; verbunden ist. Der hierzu erforderliche Inertgasstrom wird über die Regeleinrichtung 22 geregelt. Der Gaseinlaßöffnung 14 gegenüberliegend hat die Hohlkathode 10 eine Gasauslaßöffnung 13, aus der das Inertgas 23 nach Durchlaufen des Bereiches zwischen Kathodenmaterial 12 und Anode 11 herausströmt. Geodätisch oberhalb der Gasauslaßöffnung 13 ist mit einem Mündungsbereich eine Zuführung 16 für reaktives Gas, in diesem Fall eine Oxidationsmittelzuführung 16 angeordnet, durch die Sauerstoff in die Beschichtungskammer 2 über die Regeleinrichtung 22 geregelt einführbar ist. Geodätisch oberhalb der Oxidationsmittelzuführung 16 ist ein Bauteil 1, hier schematisch als Gasturbinenschaufel dargestellt, in einer Halteeinrichtung 8 gehalten. Die Halteeinrichtung 8 ist über eine Zusatzspannungsversorgung 26, die durch die Regeleinrichtung 22 angesteuert wird, mit der Hohlkathode 10 elektrisch verbindbar. Eine zwischen die Hohlkathode 10 und die Haltevorrichtung 8 respektive das Bauteil 1 anlegbare Gleichspannung kann einer Oberflächenreinigung des Bauteils 1 durch ionisierte Inertgasatome dienen. Die Halteeinrichtung 8 hat vorzugsweise eine nicht näher dargestellte Antriebsvorrichtung, die mit einer Regeleinrichtung 22 verbunden ist. Die Antriebsvorrichtung gewährleistet eine kontinuierliche Drehung des Bauteils 1 um seine Längsachse 27. Geodätisch oberhalb des Bauteils 1 ist eine Beheizungseinrichtung 9 zur Beheizung des Bauteils 1 über Wärmestrahlung und/oder Konvektion angeordnet, die ebenfalls mit der Regeleinrichtung 22 verbunden ist. Die Beheizungseinrichtung 9 kann selbstverständlich je nach Anforderung auch auf gleichem geodätischen Niveau neben dem Bauteil 1 angeordnet sein. In der Beschichtungskammer 2 ist weiterhin eine Vakuumdruckmeßeinrichtung 19 vorgesehen, die ebenfalls mit der Regeleinrichtung 22 verbunden ist. An dem Bauteil 1 ist zur Erfassung seiner Bauteiltemperatur bzw. Bauteiltemperaturverteilung zumindest ein Temperaturgeber 17, beispielsweise ein Thermoelement, angeordnet, welches ebenfalls mit der Regeleinrichtung 22 verbunden ist. Auch die Vakuumerzeugungseinrichtung 18 ist mit der Regeleinrichtung 22 verbunden.

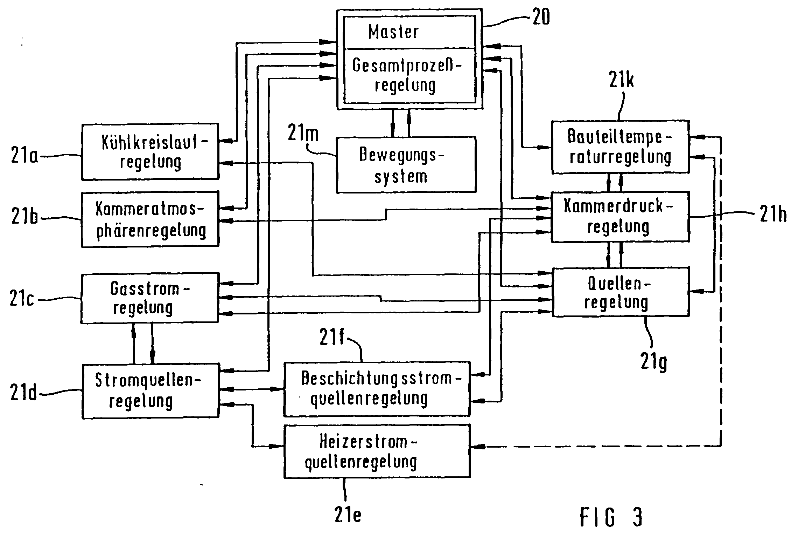

Die Regeleinrichtung 22 weist wie in FIG 3 schematisch dargestellt ein Mastersystem 20, welchem eine Vielzahl von Subsystemen 21a bis 21m zu- und untergeordnet sind. Das Mastersystem 20 übernimmt die Koordinationsaufgaben zur Regelung eines gesamten Beschichtungszyklusses, insbesondere der Anlagengrößen der Beschichtungseinrichtung 15, der Prozeßregelung sowie der Bewegungssteuerung des Bauteils 1. Durch das Mastersystem 20 wird der zeitliche Gesamtablauf des Beschichtungsprozesses sowie die Verwaltung der einzelnen Subsysteme 21a bis 21m sowie deren Regelkreise übernommen.

Ein vollständiger Beschichtungsprozeß läßt sich prozeßtechnisch in die Teilaufgaben
a) Einstellen des Bauteilzustandes vor dem Beschichten (Vorwärmen auf Ankeimungstemperatur, Umgebungsdruck auf Beschichtungsdruck absenken),
b) Abscheidung der Wärmedämmschicht in den geforderten Eigenschaften hinsichtlich Struktur, Haftung, Schichtdicke, und
c) Zurückführung des Bauteilzustandes auf Umgebungsbedingungen (Raumtemperatur und atmosphärischen Luftdruck) gliedern.

Die Prozeßführung durch das Mastersystem 20 ist so gestaltet, daß für den zeitlichen Ablauf der einzelnen Prozeßschritte, die jeweils erforderlichen Subsysteme 21a bis 21m aktiviert sind und eine Ausregelung der relevanten Prozeß- und/oder Anlagengrößen durchführen.

Während eines gesamten Beschichtungszykluses erfolgt durch eine Kühlkreislaufregelung 21a eine Kühlung sämtlicher zu kühlender Komponenten der Beschichtungsvorrichtung 15 sowie weiterer nichtdargestellter Anlagenteile, so daß diese auf einer konstanten Temperatur für einen einwandfreien Betrieb gehalten werden. Bei einer Beschichtungsvorrichtung 15, welche zusätzlich zur Beschichtungskammer 2 noch eine nichtdargestellte mit einer ebenfalls nichtdargestellten Schleuse verbundene Ladekammer aufweist, erfolgt eine Vorwärmung des Bauteils 1 vorzugsweise in der Ladekammer. Selbstverständlich ist auch eine eigens der Vorwärmung dienende von der Ladekammer räumlich, z.B. über eine Schleuse, getrennte Vorwärmekammer vorsehbar. Die Ladekammer wird auf einen Druck von 10 mbar evakuiert, wobei die Regelung über das Subsystem 21h, die Kammerdruckregelung, erfolgt. Der Sollwert des Kammerdrucks ist frei vorgebbar. Die Kammerdruckregelung 21h regelt einen Vakuumpumpstand mit angeschlossener Druckmeßstelle 19 und hat einen separat programmierbaren Druckregelkreis, der für die Ausregelung des Druckes innerhalb einer frei vorgebbaren Druckschwankung sorgt. Die Ladekammer wird anschließend auf 200 mbar mit Argon geflutet, erneut auf 10 mbar evakuiert und anschließend noch einmal auf 800 mbar mit Argon geflutet. Anschließend erfolgt eine konvektive Vorwärmung des Bauteils auf bis zu 700 °C. Hierbei wird über das Subsystem Kammerdruckregelung 21h der Druck in der Ladekammer konstant gehalten. Die Erwärmung des Bauteils 1 wird über die Subsysteme Heizerstromquellenregelung 21e und Bauteiltemperaturregelung 21k gleichzeitig geregelt. Hierzu werden die Meßwerte des Temperaturgebers 17 ausgewertet und daraus ein Aufheizgradient ermittelt. Für den Aufheizgradienten ist ein Sollwert vorgebbar, wobei dieser als Führungsgröße für das Subsystem Heizerstromquellenregelung 21e dient. Weitere Prozeß- und Anlagengrößen sind die Vorwärmtemperatur des Bauteils 1 sowie eine Lüfterdrehzahl zur Erzeugung der konvektiven Vorwärmung mittels eines nicht näher dargestellten Lüfters. Für eine gleichmäßige Vorwärmung wird das Bauteil 1 um seine Längsachse 27 rotiert, was über das Subsystem Bewegungssystem 21m gesteuert wird. Das Erreichen der Vorwärmtemperatur, insbesondere 700 °C, wird von dem Subsystem Bauteiltemperaturregelung 21k erfaßt. Danach findet ein Übergang auf eine Strahlungsbeheizung des Bauteils 1 statt. Hierzu wird der nichtdargestellte Lüfter ausgeschaltet und neue Sollwerte für die Bauteiltemperatur und den Kammerdruck vorgegeben, welche der erforderlichen Ankeimungstemperatur sowie dem Beschichtungsdruck in der Beschichtungskammer 2 entsprechen. In der Beschichtungskammer 2 wird über das Subsystem Gasstromregelung 21c sowie das Subsystem Stromquellenregelung 21d das Zuströmen von Reaktivgas zur Einstellung der geforderten Gasatomstöchiometrie bei der Schichtabscheidung geregelt. Über die Subsysteme Quellenregelung 21g und Beschichtungsstromquellenregelung 21f wird die Beschichtungsquelle 6 aktiviert und die Konzentration des Beschichtungsmaterial, insbesondere Zirkon, in einer Metallatomwolke ausgeregelt.

Das Subsystem Bauteiltemperaturregelung 21k erfaßt das Erreichen der Ankeimungstemperatur. Sind Ankeimungstemperatur und Beschichtungsdruck gleichzeitig erreicht, so erfolgt eine Abschaltung des Subsystems Heizerstromquellenregelung 21e. Die Schleuse zwischen Ladekammer und Beschichtungskammer 2 wird geöffnet und über das Subsystem Bewegungssystem 21m wird die Verschiebung des Bauteils 1 in die Beschichtungskammer 2 gesteuert. Der Kammerdruck in der Beschichtungskammer 2 wird über das Subsystem Kammerdruckregelung 21h auf einen frei vorgebbaren Sollwertebereich des Vakuumdrucks eingeregelt. Über das Subsystem Beschichtungsquellenregelung 21g wird vor Einführung des Bauteils 1 in die Beschichtungskammer 2 die Beschichtungsquelle 6 auf die stationäre Bedingung für den Abscheidungsprozeß eingeregelt. Während des Abscheidungsprozesses erfolgt über das Subsystem Kammerdruckregelung 21h eine Ausregelung des Vakuumdrucks in dem vorgegebenen Sollwertebereich gleichzeitig mit einer über eine das Subsystem Bauteiltemperaturregelung 21k ausgeführten Einregelung der Bauteiltemperatur in den vorgegebenen Sollwertebereich zur Erzielung einer keramischen Wärmedämmschicht mit stabförmiger Mikrostruktur. Gleichzeitig erfolgt eine Gasatmospährenregelung über das Subsystem 21b Kammeratmosphärenregelung. Über das Subsystem Bewegungssystem 21m erfolgt eine gezielte Bewegungsführung des Bauteils 1 zur besonders günstigen Ausnutzung der durch die Beschichtungsquelle 6 und die Zuführung des reaktiven Gases 16 erzeugte Wolke aus Beschichtungsmaterial. Durch das Subsystem Gasstromregelung 21c wird der stationäre Zustrom von Reaktivgas in die Beschichtungskammer 2 innerhalb einer definierten Schwankung für die Kammeratmosphäre (Subsystem Kammeratmosphärenregelung 21b) ausgeführt. Erhöhte Sauerstoffpartialdrücke, die zur Lichtbogenbildung in der Beschichtungsquelle 6 führen können, werden durch eine Überwachung des Stromflusses und/oder der Spannung der Beschichtungsquelle 6 vorzeitig erkannt und durch rechtzeitige Leistungsverminderung der Beschichtungsquelle 6 vermieden. Dies wird insbesondere durch das Subsystem Stromquellenregelung 21d durchgeführt.

Nach Beendigung des Beschichtungsvorganges wird das Bauteil 1 aus der Beschichtungskammer 2 in die Ladekammer gebracht und auf etwa 500 °C mit vorgegebenen Abkühlgradienten abgekühlt. In der Ladekammer erfolgt eine Druckerhöhung durch Zuströmung von Argon und Aktivierung des Lüfters, wobei nicht näher ausgeführte Kühleinrichtungen als eine Wärmesenke wirken. Die Abkühlung wird über den Temperaturgeber 27 und das Subsystem Bauteiltemperaturregelung 21k überwacht. Durch Druckregelung, Regelung der Lüfterdrehzahl sowie Regelung der Zuströmung von Argon wird die Abkühlgeschwindigkeit adaptiv ausgeregelt. Nach Abkühlung der Bauteiltemperatur auf 500 °C wird der Druck in der Ladekammer auf über ein bar durch Zuströmen von Argon über das Subsystem Kammeratmosphärenregelung 21h geregelt. Das Bauteil wird mit hohem Abkühlgradienten auf etwa 100 °C abgekühlt. Anschließend findet ein geregelter Druckausgleich zwischen der Ladekammer und der Umgebungsatmosphäre durch das Subsystem Kammerdruckregelung 21h statt. Der vollständige von dem Mastersystem 20 koordinierte Beschichtungszyklus ist damit abgeschlossen. Der Beschichtungsvorgang ist für jedes geeignete Beschichtungsverfahren, insbesondere ein PVD-Verfahren, wie das reaktive Gasflußsputter-Verfahren oder das Elektronenstrahl-PVD-Verfahren, durchführbar.

Ein Beschichtungsvorgang mittels eines Elektronenstrahl-PVD-Verfahrens kann ähnlich dem oben geschilderten Vorgang durchgeführt werden mit einer entsprechenden Beschichtungsvorrichtung 15.

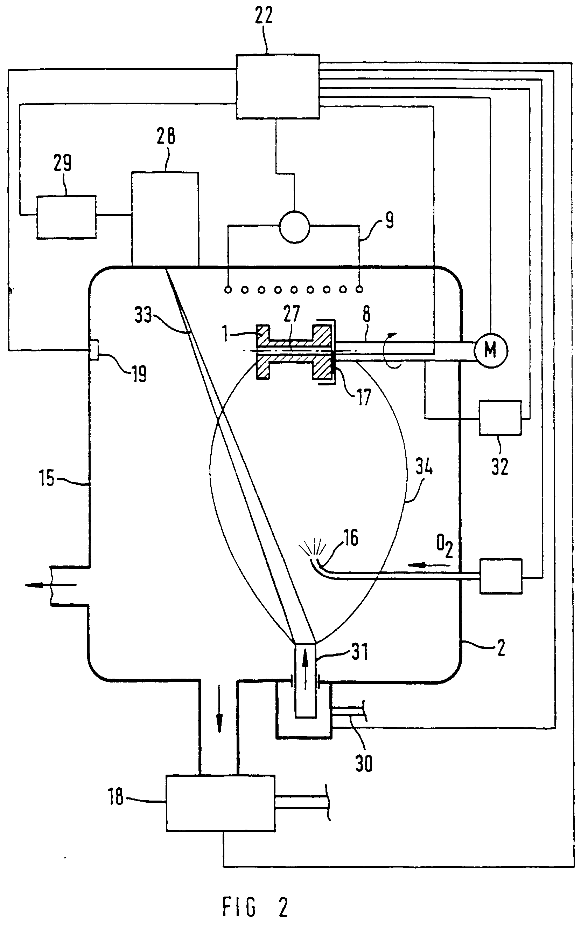

In FIG 2 ist zur Erläuterung schematisch und nicht maßstäblich eine Beschichtungsvorrichtung 15 zur Durchführung eines Elektronenstrahl-PVD-Verfahrens dargestellt. Die Beschichtungsvorrichtung weist eine Beschichtungskammer 2 auf, in der durch eine Vakuumerzeugungseinrichtung 18 ein Vakuum von unter 10⁻² Pa erzeugbar ist. Außerhalb der Beschichtungskammer 2 ist Elektronenstrahlkano- ne 28 angeordnet, die über eine Stromversorgung 29 verbunden ist. Weiterhin besteht zwischen der Stromversorgung 29 und der Regeleinrichtung 22 eine Verbindung. Geodätisch unterhalb der Elektronenstrahlkanone 28 befindet sich eine Vorschubeinrichtung 30, die ein keramisches Beschichtungmaterial 31 in Stangenform in die Beschichtungskammer fördert. Auch die Vorschubeinrichtung 30 ist mit der Regeleinrichtung 22 verbunden. Geodätisch oberhalb der Vorschubeinrichtung 30 ist ein Bauteil 1, hier schematisch als Gasturbinenschaufel dargestellt, in einer Halteeinrichtung 8 gehalten. Die Halteeinrichtung 8 ist an eine Zusatzspannungsversorgung 32 angeschlossen, die wiederum mit der Regeleinrichtung 22 verbunden ist. Eine zwischen der Zusatzspannungsversorgung 22 und die Haltevorrichtung 8 respektive das Bauteil 1 anlegbare Gleichspannung kann eine Oberflächenreinigung des Bauteiles 1 durch ionisierte Inertgasatome oder der Beschleunigung von Atomen des Beschichtungsmaterials auf die Oberfläche des Bauteiles 1 dienen. Die Haltevorrichtung 8 hat vorzugsweise eine nicht näher dargestellte Antriebsvorrichtung, die mit einer Regeleinrichtung 22 verbunden ist. Die Antriebseinrichtung gewährleistet eine kontinuierliche Drehung des Bauteiles 1 um seine Längsachse 27. Geodätisch oberhalb der Vorschubeinrichtung 30 und unterhalb des Bauteiles 1 ist der Mündungsbereich einer Zuführung 16 für reaktives Gas, in diesen Fall eine Oxidationsmittelzuführung 16 angeordnet, durch die Sauerstoff in die Beschichtungskammer 2 gezielt über die Regeleinrichtung 22 einführbar ist. Zur Beheizung des Bauteiles 1 ist geodätisch oberhalb des Bauteiles 1 eine Beheizungseinrichtung 9 angeordnet, die ebenfalls mit der Regeleinrichtung 22 verbunden ist. In der Beschichtungskammer 2 ist weiterhin eine Vakuumdruckmeßeinrichtung 19 vorgesehen, die ebenfalls mit der Regeleinrichtung 22 verbunden ist. An dem Bauteil 1 ist zur Erfassung seiner Bauteiltemperatur bzw. Bauteiltemperaturverteilung zumindest ein Temperaturgeber 17, beispielsweise ein Thermoelement, angeordnet, welches ebenfalls mit der Regeleinrichtung 22 verbunden ist. Auch die Vakuumerzeugungseinrichtung 18 ist mit der Regeleinrichtung 22 verbunden.

Eine Regeleinrichtung 22 zur Durchführrung eines Beschichtungsprozesses mittels Elektronenstrahl-PVD-Verfahrens ist analog zu der in FIG 3 dargestellten Einrichtung aufgebaut. Lediglich eine Verbindung und Wechselwirkung zwischen den Subsystemen Gasstromregelung 21c und Quellenregelung 21g kann unterbleiben. Die Ladekammer wird auf einen Druck von 10⁻² Pa evakuiert, wobei die Regelung über das Subsystem 21h, die Kammerdruckregelung, erfolgt. Der Sollwert des Kammerdrucks ist hierbei frei vorgebbar.

Das Erreichen der Vorwärmtemperatur, insbesondere 700°C, wird von dem System Bauteiltemperaturregelung 21k erfaßt. Danach wird mittels einer Reaktivgaszufuhr in die Vorwärmkammer über eine nicht näher dargestellte Reaktivgaseinleitungseinrichtung der Kammerdruck auf den Beschichtungsdrucksollwert von bis zu 5 Pa angehoben. Dabei ist die Bauteiltemperaturegelung 21k gleichzeitig wirksam und hält die Bauteiltemperatur auf 700 °C. Die Kammerdruckregelung 21h und die Kam-meratmosphärenregelung 21b sind ebenfall aktiviert und überwachen die Einhaltung des Kammerdrucksollwertes als Gesamtdruck und die Einstellung der geforderten Kammeratmosphärenzusammensetzung als Partialdrücke der Einzelgase oder als Gesamtdruck der vorher eingeregelten Gaszuflüsse. Erst wenn durch die Kammerdruckregelung 21b, die Bauteiltemperaturegelung 21k und die Kammeratmosphärenregelung 21b zeitgleich die Einhaltung der Sollwerte signalisieren, erfolgt eine weitere Vorwärmung des Bauteiles 1 auf Ankeimungstemperatur, indem ein neuer Sollwert für die Bauteiltemperatur vorgegeben wird, welcher der Ankeimungstemperatur entspricht.

In der Beschichtungskammer 2 wird zeitgleich über die Subsysteme Kammerdruckregelung 21k und Kammeratmosphärenregelung 21b der erforderliche Beschichtungsdruck und die Gasatmosphärenzusammensetzung ausgeregelt. Erst wenn für beide Größen - Kammerdruck und Gasatmosphärenzusammensetzung - die Sollwerte zeitgleich signalisiert werden, erfolgt durch die Elektronenstrahlkanone 28 die Erzeugung eines Elektronenstrahles 33, der auf das Beschichtungmaterial 31 gerichtet ist und das keramische Beschichtungsmaterial verdampft. Dabei werden über die Quellenregelung 21g, aktiviert durch die Regeleinrichtung 22, der Vorschub des keramischen Beschichtungsmaterials 31 über die Vorschubeinrichtung 30 und die Leistung der Elektronenstrahlkanone 28 über die Stromversorgung 29 auf stationäre Verdampfungsbedingungen eingeregelt.

Über das Subsystem Bewegungssystem 21m erfolgt eine gezielte Bewegungsführung des Bauteils 1 zur besonders günstigen Ausnutzung des Beschichtungsmaterials in der Beschichtungsmaterialwolke 34. Durch das Subsystem Kammeratmosphärenregelung 21b gekoppelt mit dem Subsystem Gasstromregelung 21c wird der stationäre Zustrom von Reaktivgas in die Beschichtungskammer 2 innerhalb einer definierten Schwankung für die Kammeratmosphäre ausgeführt. Nach Beendigung der Beschichtung erfolgt eine Abkühlung wie weiter oben bereits ausgeführt.

Die Erfindung zeichnet sich dadurch aus, daß während des Beschichtungsvorgangs, d.h. einer Abscheidung einer keramischen Wärmedämmschicht auf einem Bauteil, mehrere, insbesondere mehr als zwei, vorzugsweise die wesentlichen zur Erreichung einer vorgegebenen Mikrostruktur der Wärmedämmschicht erforderlichen Prozeßgrößen gleichzeitig und gemeinsam in einem jeweiligen Sollwertbereich ausgeregelt werden. Korrespondierend mit dem Gesamtprozeß werden neben den Prozeßgrößen auch die Anlagengrößen im Komplex ausgeregelt. Darüber hinaus wird ein vollständiger Beschichtungszyklus umfassend einen Aufwärmvorgang, den eigentlichen Beschichtungsvorgang sowie einen Abkühlvorgang durch ein Mastersystem in vorab bestimmbarer Abfolge koordiniert. Eine entsprechende Regelung umfaßt eine geeignete Anpassung der Prozeßgrößen bei Auftreten von Störeinflüssen.

## Patentansprüche

1. Verfahren zur Beschichtung eines Bauteils (1) mit einer keramischen, stengelkristallinen Wärmedämmschicht (3), bei dem das Bauteil (1) in einer Beschichtungskammer (2) angeordnet und auf einer Bauteiltemperatur gehalten wird, und in der Beschichtungskammer (2) ein Vakuum eingestellt wird, wobei zumindest während des Beschichtungsprozesses mit einer Abscheidung von die Wärmedämmschicht (3) bildendem Material auf dem Bauteil (1) die Prozeßgrößen Vakuumdruck, Bauteiltemperatur und/oder Atmosphärenzusammensetzung, über eine Regeleinrichtung (22) gemeinsam und gleichzeitig geregelt werden, so daß sie in einem jeweiligen Sollwertebereich liegen wodurch die Wärmedämmschicht (3) mit einer Stengelstruktur auf dem Bauteil (1) aufwächst.

2. Verfahren nach Anspruch 1, bei dem während des Beschichtungsprozesses in die Beschichtungskammer (2) ein Reaktivgas, wie Sauerstoff oder Stickstoff, eingeführt wird, wobei die Zuflußmenge an Reaktivgas und/oder der Partialdruck des Reaktivgases als weitere Prozeßgröße bzw. weitere Prozeßgrößen mit den anderen Prozeßgrößen gemeinsam geregelt wird bzw. werden.

3. Verfahren nach Anspruch 1 oder 2, bei dem das Bauteil (1) relativ zu einer Beschichtungsquelle (6) zur Erzeugung des Materials der Wärmedämmschicht (3) bewegt wird und die Materialabgabe der Beschichtungsquelle (6) und/oder die relative Bewegung des Bauteils (1) als Anlagengröße bzw. Anlagengrößen mit den Prozeßgrößen gemeinsam geregelt wird bzw. werden.

4. Verfahren nach einem der vorhergehenden Ansprüche, bei dem der Sollwertebereich der Bauteiltemperatur zwischen 900 °C und 1150 °C, insbesondere zwischen 950 °C und 1050 °C, und der Sollwertebereich des Vakuumdrucks zwischen 10⁻³ Pa und 10 Pa, insbesondere zwischen 10 Pa und 5 Pa, liegen.

5. Verfahren nach einem der vorhergehenden Ansprüche, bei dem der Sollwertebereich des Partialdruckes des Reaktivgases, zwischen 10⁻² Pa und 5 Pa, insbesondere um 5 x 10⁻¹ Pa, liegt.

6. Verfahren nach einem der vorhergehenden Ansprüche, welches auf ein Bauteil (1) mit Teilbereichen (7a,7b) stark unterschiedlicher Massenkonzentration, wie eine Turbinenschaufel, insbesondere eine Lauf- oder Leitschaufel einer Industriegasturbine, angewandt wird, wobei in dem Bauteil (1) eine weitgehend gleichmäßige Durchwärmung eingestellt wird.

7. Verfahren nach einem der vorhergehenden Ansprüche, bei dem das Bauteil (1) einen ersten Teilbereich (7a) mit einer ersten Wandstärke und einen zweiten Teilbereich (7b) mit einer zweiten Wandstärke aufweist, wobei die Wandstärken in einem Verhältnis von 1:5 bis 1:200, insbesondere von 1:10 bis 1:100, zueinander stehen.

8. Beschichtungsvorrichtung (19) für eine Beschichtung eines metallischen Bauteils (1) einer Gasturbine mittels Physical Vapour Deposition (PVD) mit einer keramischen stengelkristallinen Wärmedämmschicht (3) auf einem Bauteil (1) mit
a) einer Beheizungseinrichtung (9) zur Erwärmung des Bauteils (1),
b) einer Vakuumerzeugungseinrichtung (18),
c) einer Vakuumdruckmeßeinrichtung (19),
d) zumindest einem Temperaturgeber (17) zur Bestimmung der Temperatur des Bauteils (1) und
e) einer Regeleinrichtung (22) zur gemeinsamen und gleichzeitigen Regelung der Prozeßgrößen, Temperatur des Bauteils (1), Vakuumdruck und/oder Gaszusammensetzung bei dem PVD-Beschichtungsprozeß.

9. Beschichtungsvorrichtung (15) nach Anspruch 8, mit
f) einer Halteeinrichtung (8) zur Positionierung des Bauteils (1),
g) einer Beschichtungsquelle (6) umfassend
g1) eine Hohlkathode (10), welche von einem Inertgas durchströmbar ist sowie ein Kathodenmaterial (12) und eine Anode (11) umfaßt, eine der Halteeinrichtung (8) zugewandte Gasauslaßöffnung (13) sowie eine Gaseinlaßöffnung (14) für Inertgas aufweist, und
bei der das Kathodenmaterial eine Legierung aus Zirkon, insbesondere mit einem Stabilisatormetall, wie Yttrium, ist und eine Zuführung (16) für Reaktivgas, insbesondere für eine Oxidation des Zirkons, außerhalb der Hohlkathode (10) vorgesehen ist, oder
g2) eine Elektronenstrahlkanone (28), welche mittels eines fokusierten Elektronenstrahls ein Ingot (31) mit der Zusammensetzung des Beschichtungsmaterials durch Abscannen seiner Oberfläche verdampft, wobei das Ingot (31) durch eine Vorschubeinrichtung (30) nachschiebbar ist.

10. Beschichtungsvorrichtung (15) nach Anspruch 8 oder 9, bei der die Regeleinrichtung (22) hierachisch mit einem Mastersystem (20) zur Koordination des Gesamtablaufs des Beschichtungsprozesses und einer Mehrzahl von Subsystemen (21) zur Regelung jeweils einer oder mehrerer Prozeß- und/oder Anlagengrößen ausgeführt ist.

## Claims

1. Method for coating a component (1) with a ceramic, columnar crystalline thermal insulation layer (3), in which the component (1) is arranged in a coating chamber (2) and is maintained at a component temperature, and a vacuum is established in the coating chamber (2), the process parameters of vacuum pressure, component temperature and/or atmosphere composition, being controlled together and simultaneously via a control device (22), at least during the coating process with deposition on the component (1) of material forming the thermal insulation layer (3), so that these parameters are in a respective set-point value range, as a result of which the thermal insulation layer (3) grows with a columnar structure on the component (1).

2. Method according to Claim 1, in which a reactive gas, such as oxygen or nitrogen, is fed into the coating chamber (2) during the coating process, the input flow rate of reactive gas and/or the partial pressure of the reactive gas being controlled, together with the other process parameters, as a further process parameter or further process parameters.

3. Method according to Claim 1 or 2, in which the component (1) is moved relative to a coating source (6) for producing the material of the thermal insulation layer (3) and the material output of the coating source (6) and/or the relative motion of the component (1) being controlled in common with the process parameters, as a system parameter or system parameters.

4. Method according to one of the preceding claims, in which the set-point value range of the component temperature is between 900EC and 1150EC, in particular between 950EC and 1050EC, and the set-point value range of the vacuum pressure is between 10⁻³ Pa and 10 Pa, in particular between 10 Pa and 5 Pa.

5. Method according to one of the preceding claims, in which the set-point value range of the partial pressure of the reactive gas is between 10⁻² Pa and 5 Pa, in particular about 5 H 10⁻¹ Pa.

6. Method according to one of the preceding claims, which is applied to a component (1) with sub-regions (7a, 7b) of greatly different mass concentration, such as a turbine blade, in particular a rotor blade or guide vane of an industrial gas turbine, substantially uniform heating being established through the component (1).

7. Method according to one of the preceding claims, in which the component (1) has a first sub-region (7a) having a first wall thickness and a second sub-region (7b) having a second wall thickness, the wall thicknesses being in a ratio of 1:5 to 1:200, in particular 1:10 to 1:100 to one another.

8. Coating device (19) for coating a metallic component (1) of a gas turbine by means of Physical Vapour Deposition (PVD) with a ceramic, columnar crystalline thermal insulation layer (3) on a component (1), having
a) a heating device (9) for heating the component (1),
b) a vacuum-generating device (18),
c) a vacuum-pressure measuring device (19),
d) at least one temperature sensor (17) for determining the temperature of the component (1), and
e) a control device (22) for controlling the process parameters in common and simultaneously, - temperature of the component (1), vacuum pressure and/or gas composition during the PVD coating process.

9. Coating device (15) according to Claim 8, having
f) a holding device (8) for positioning the component (1),
g) a coating source (6), comprising
g1) a hollow cathode (10), through which an inert gas can flow and which comprises a cathode material (12) and an anode (11), and has a gas outlet opening (13) facing the holding device (8), as well as a gas inlet opening (14) for inert gas, and in which the cathode material is an alloy of zirconium, in particular with a stabilizer metal, for example yttrium, and a feed (16) for reactive gas, in particular for oxidation of zirconium, is provided outside the hollow cathode (10), or
g2) an electron gun (28) which, by means of a focused electron beam, evaporates an ingot (31) having the composition of the coating material, by scanning its surface, it being possible to displace the ingot (31) using an advance device (30).

10. Coating device (15) according to Claim 8 or 9, in which the control device (22) is configured hierarchically with a master system (20) for coordinating the overall running of the coating process, and a multiplicity of subsystems (21), each for controlling one or more process and/or system parameters.

## Revendications

1. Procédé pour revêtir un composant (1) d'une couche (3) thermo-isolante céramique, à structure cristalline colonnaire, suivant lequel le composant (1) est disposé dans une chambre (2) de revêtement et maintenu à une température de composant, et un vide est établi dans la chambre (2) de revêtement, les paramètres de processus suivants, pression de vide, température du composant et/ou composition de l'atmosphère, étant, au moins pendant le processus de revêtement par déposition sur le composant (1) d'un matériau constituant la couche (3) thermo-isolante, régulés conjointement et simultanément au moyen d'un équipement (22) de régulation, de façon qu'ils se situent dans une plage respective de valeurs de consigne, de sorte que la couche (3) thermo-isolante croît sur le composant (1) en ayant une structure colonnaire.

2. Procédé suivant la revendication 1, suivant lequel on introduit pendant le processus de revêtement un gaz réactif comme de l'oxygène ou de l'azote dans la chambre (2) de revêtement, la quantité d'apport de gaz réactif et/ou la pression partielle du gaz réactif étant régulée(s) conjointement avec les autres paramètres de processus, en tant que paramètre(s) de processus supplémentaire(s).

3. Procédé suivant la revendication 1 ou 2, suivant lequel le composant (1) est déplacé par rapport à une source (6) de revêtement destinée à produire le matériau de la couche (3) thermo-isolante, et l'émission de matériau de la source (6) de revêtement et/ou le déplacement relatif du composant (1) étant régulé(s) conjointement avec les paramètres de processus, en tant que paramètre(s) d'appareillage.

4. Procédé suivant l'une des revendications précédentes, suivant lequel la plage de valeurs de consigne de la température du composant s'étend entre 900°C et 1150°C, notamment entre 950°C et 1050 °C, et la plage de valeurs de consigne de la pression de vide s'étend entre 10⁻³ Pa et 10 Pa, notamment entre 10 Pa et 5 Pa.

5. Procédé suivant l'une des revendications précédentes, suivant lequel la plage de valeurs de consigne de la pression partielle du gaz réactif s'étend entre 10⁻² Pa et 5 Pa, notamment autour de 5 x 10⁻¹ Pa.

6. Procédé suivant l'une des revendications précédentes, qui est mis en oeuvre pour un composant (1) comportant des régions (7a, 7b) partielles de concentration massique fortement différente, comme une aube de turbine, notamment une aube mobile ou directrice d'une turbine à gaz industrielle, un échauffement essentiellement uniforme étant établi dans le composant (1 ).

7. Procédé suivant l'une des revendications précédentes, suivant lequel le composant (1) comporte une première région (7a) partielle possédant une première épaisseur de paroi et une seconde région (7b) partielle possédant une seconde épaisseur de paroi, les épaisseurs de paroi se trouvant dans un rapport mutuel de 1:5 à 1:200, notamment de 1:10 à 1:100.

8. Dispositif (15) de revêtement pour revêtir un composant (1) métallique d'une turbine à gaz par déposition physique en phase vapeur d'une couche (3) thermo-isolante céramique à structure cristalline colonnaire sur un composant (1), comportant
a) un équipement (9) de chauffage pour chauffer le composant (1),
b) un équipement (18) d'obtention de vide,
c) un équipement (19) de mesure de la pression de vide,
d) au moins un capteur (17) de température pour déterminer la température du composant (1), et
e) un équipement (22) de régulation pour la régulation conjointe et simultanée des paramètres de processus suivants, température du composant (1), pression de vide et/ou composition du gaz, pour le processus de revêtement par déposition physique en phase vapeur.

9. Dispositif (15) de revêtement suivant la revendication 8, comportant
f) un équipement (8) de maintien pour positionner le composant (1)
g) une source (6) de revêtement, comportant
g1) une cathode (10) creuse, dans laquelle peut passer du gaz inerte et qui comprend un matériau (12) de cathode et une anode (11), et comporte pour le gaz inerte une ouverture (13) de sortie de gaz, tournée vers l'équipement (8) de maintien, ainsi qu'une ouverture (14) d'entrée de gaz, et
le matériau de cathode étant un alliage de zirconium, notamment avec un métal stabilisateur comme de l'yttrium, et une alimentation (16) en gaz réactif, notamment pour une oxydation du zirconium, étant prévue en dehors de la cathode (10) creuse,
ou comportant
g2) un canon (28) à électrons qui, au moyen d'un faisceau électronique focalisé, vaporise un lingot (31) ayant la composition du matériau de revêtement par balayage de sa surface, un équipement (30) d'avance permettant de faire avancer le lingot (31) en le poussant.

10. Dispositif (15) de revêtement suivant la revendication 8 ou 9, dans lequel l'équipement (22) de régulation est réalisé à structure hiérarchique, avec un système (20) maître pour la coordination du déroulement global du processus de revêtement, et une pluralité de sous-systèmes (21) pour réguler chacun un ou plusieurs paramètres de processus et/ou d'appareillage.
